# EUROPEAN PATENT SPECIFICATION

(11) **EP 0 420 507 B1**
(45) Date of publication and mention of the grant of the patent: **20.03.1996**
(21) Application number: 90310314.1
(22) Date of filing: 20.09.1990
(51) Int. Cl.: H03J 3/12, H04Q 7/34

(54) **A method of tuning and compensating the received signal strength indicator in a radio telephone**
Verfahren zur Abstimmung und zum Ausgleich des Signalstärkeindikators in einem Funk-Telefon
Méthode pour l'accord et la compensation de l'indicateur d'intensité de signal reçu dans un radio téléphone

(30) Priority: 25.09.1989 FI 894530
(43) Date of publication of application: 03.04.1991
(73) Proprietor: NOKIA MOBILE PHONES LTD., SF-24101 Salo (FI)
(72) Inventor: Vaisanen, Risto, SF-24100 Salo (FI); Leppanen, Aki, SF-24260 Salo (FI)
(74) Representative: Singleton, Jeffrey

(56) References cited:
- WO-A-86/00769
- PATENT ABSTRACTS OF JAPAN vol. 13, no. 292 (E-782) 6 July 1989 & JP-A-1 072 631
- PATENT ABSTRACTS OF JAPAN vol. 15, no. 405 (E-1122) 16 October 1991 & JP-A-3 165 127

## Description

The invention relates to a method of tuning and compensating the signal strength indicator in a radio telephone having a logic section which controls the operation.

In radio telephones a received signal strength indicator (RSSI) is used, with which the received signal strength in the antenna interface can be measured. The information of the received antenna signal strength is needed in order to select that channel of the radio telephone, which receives the strongest signal. During operation the-measurement is performed in practice so that a DC voltage level is measured, which is proportional to the strength of the intermediate frequency signal produced in the intermediate frequency section of the receiver. In prior art methods this voltage is generally measured using an A/D-converter or comparators, with which it is possible to identify e.g. three signals with different strengths see e.g. WO 86/00769.

In a measurement of this kind there are two factors producing a considerable inaccuracy. Temperature variations cause the biggest inaccuracy by causing the amplification in the RF and IF sections of the receiver to change. The second factor consists of the unevenness of the RF filter frequency responses, which at different frequencies produce different measurement results.

In prior art it is generally tried to compensate for the temperature dependent changes by means of analog technology, e.g. with temperature dependent NTC resistors. The changes of individual radio telephone units can be somewhat different at various temperatures, and thus the compensating circuitry designed for a radio telephone type in series production does not necessarily function in a desired manner for every unit. On the other hand the compensating circuitry could function inaccurately, due to component tolerances.

Up to now the measurement errors caused by the frequency response of filters have not generally been corrected in any way, but instead sufficiently high requirements have been imposed on the frequency response in the filter design, whereby the size and the price of the filters increase correspondingly.

Generally the radio telephone casing has to be opened for the tuning, so that the various tuning points can be reached.

The object of the invention is to devise a method, with which the above mentioned prior art problems and drawbacks are obviated.

The present invention is defined in the appended claims.

In accordance with an embodiment of the invention individual tuning results are stored for selected operating conditions into the radio telephone's memory as compensating values, whereby the respective signal strength indicator reading is corrected by the stored compensating values, when the radio telephone is in operation. Preferably the tuning is made by connecting the tuning equipment to the normal external connections of the radio telephone, the tuning being made without opening the radio telephone casing. This tuning arrangement may be applied to the final testing in series production of radio telephones.

The radio telephone for use in a method according to the invention has sensors connected to the logic section and detecting the radio telephone's operating conditions, and an A/D-converter is arranged between the logic section and the signal strength indicator, according to whose readings, taking into account the correction made with the compensating value stored in the memory, the logic section is able to select the channel with the strongest signal.

Other preferred embodiments of the invention are presented in the subclaims.

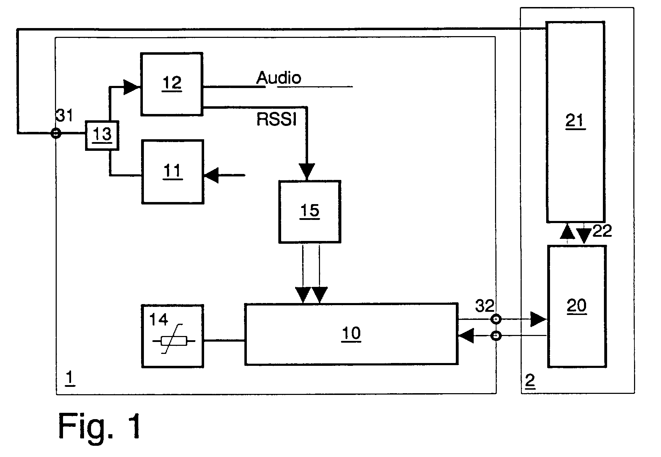

The invention is described in greater detail below by way of an example with reference to the accompanying drawing, in which the only figure is a simplified block diagram illustrating the tuning method according to the invention.

The tuning equipment 2 is connected to antenna interface 31 and auxiliary equipment interface 32 of the radio telephone to be tuned 1. The antenna signal selected for the tuning is directed from the measuring device 21, from which it is connected through the duplex filter 13 to the receiver 12. The transmitter 11 is also connected to the filter chain 13. The measuring computer 20 of the tuning equipment is connected to the radio telephone logic section 10 through the auxiliary interface 32. The measuring computer 20 can, via the logic section 10, control the radio telephone to select a desired channel (radio frequency). For each level (e.g. five different levels), for each channel range, and each temperature range, the measuring computer 20 via the logic section 10 reads the readings of the A/D-converter 15 connected to the RSSI-interface of the receiver. For all relevant operating conditions the measuring computer stores the compensation values as set values in the non-volatile memory of the logic section 10, the set values being corrected by the measuring computer with correction factors and constants for each channel range and/or for each temperature range.

The radio telephone also includes a temperature sensor 14 to detect the internal temperature of the radio telephone.

The logic section 10 includes i.a. a microprocessor, memories - especially a non-volatile memory to store programs and compensating data - and an A/D-converter, with which the voltage from the temperature sensor 14 is converted into a digital format which can be used by the microprocessor. During tuning the microprocessor 10 is connected to the measuring computer 20 via the auxiliary equipment interface 32, through which information is exchanged in both directions, e.g. information about the temperature measured by the sensor 14 to the measuring computer 20 and set values from the measuring computer to the microprocessor.

The operating channel (or channel range), the temperature (or temperature range) measured with the sensor 14, and the level range, constitute the operating conditions of the radio telephone.

The tuning of the radio telephone according to the invention is carried out in the following manner. The radio telephone is placed in a climate chamber (cold/hot chamber), and the measuring devices 21 are connected to the antenna interface 31. The tuning is initially made for the basic values at room temperature, and at the same time compensating constants for the extreme channels are measured and tuned. Thereafter the cold range and the hot range compensating factors are determined.

The basic levels are tuned in the following steps:

1) The measuring computer 20 directs the radio telephone 1 and the RF generator of the measuring devices 21 onto the middle channel and places the first level to be tuned as the initial level.

2) The computer 20 directs the radio telephone to measure the relevant RSSI level and the result is stored in the microprocessor memory.

3) The computer 20 directs the generator in sequence to the next levels and repeats the functions of the steps 1) and 2) for each level (e.g. in a radio telephone of the NMT-900 system there are five levels).

4) The compensating constants for each channel is determined as follows:

4) The respective RSSI readings at the given level are measured for the high channel and the low channel, and the deviations from the middle channel reading are calculated with the measuring computer. These deviations or compensating constants are stored in the memory of the radio telephone 1.

The compensating factors according to the temperature are determined as follows:

5) The RSSI levels are measured in cold and hot conditions detected by the temperature sensor 14 at a certain RF level, and they are compared by the measuring computer 20 with the corresponding reading at room temperature. Factors are calculated based on the comparison results, with which factors the respective measured RSSI level reading for hot or cold has to be multiplied during operation in order to get the same reading as at room temperature.

The compensating values, or the compensating constants and factors, are used by the software (in the microprocessor) during operation so that, for the channels using compensating constants, first the RSSI level is read and to it is added a compensating value, after which the level reading can be used for the radio telephone channel selection. In accordance with this method the RSSI limits remain the same from the operating viewpoint.

It should be noted that the tuning may also be carried out with operating conditions in an order differing from the above order, depending of the available climate chamber arrangement and other productions reasons. The number of operating conditions to be tuned may be selected to suit the production and the operation of the radio telephone. The number of the operating conditions can be reduced in a convenient way by using e.g. only one tuning point representing a middle range, a higher range and a lower range, respectively, for the variables channel and temperature. For example, in practice the ranges could be:
- a middle channel representing a middle range, the highest and the lowest channel representing the higher and the lower ranges; and correspondingly
- room temperature (e.g. 25 °C for the range +5...+45 °C), maximum temperature (e.g. +55 °C for the range +45...+85 °C) and minimum temperature (e.g. -10 °C for the range -25...+5 °C).

In the production the tuning can be made in the final testing, when the radio telephone is otherwise completely ready. The tuning can now be made without opening the telephone's casing. Furthermore, by suitable programming of the steps 1) to 5) in the measuring computer 20, the tuning can be made completely automatically, whereby the results of the tuning will become more reliable (no human errors), and whereby it is possible to do an individual compensation for each radio telephone regarding both temperature and channels. Due to the automation the testing throughput time and the amount of required personnel will be reduced. From a production management standpoint the inventive method signifies a great advantage, when for example the production is transferred to another plant, because the automatic tuning program does not require much training of personnel for the tuning tasks, as all information required in the tuning can be incorporated in the tuning programs of the measuring computer.

In a radio telephone realizing the method according to the invention the temperature is measured with a sensor 14 and an A/D-converter (not shown). In accordance with the operating conditions the microprocessor 10 selects from its non-volatile memory a relevant compensating constant or a set value tuned for the operating conditions, and the RSSI signal measured through the A/D-converter 15 is corrected in order to select the antenna signal which is strongest on reception.

The objects mentioned in the introduction will be met with a radio telephone 1 in a method according to the invention, because larger variations of the attenuation in the pass band can be allowed in the RF filters, corresponding to a more uneven frequency response. As a result the costs of the filters will be reduced, and it will be possible to use smaller filters. In the receiver 12 it is also possible to use cheaper components with an amplification (or attenuation) varying more or less individually at different temperatures. Tuning steps of separate modules are not needed either, because the tuning is made with an assembled radio telephone, utilizing its normal interfaces.

The invention can be applied to different types of analog and digital radio telephones, cellular radio telephones, portable and mobile radio telephones.

## Claims

1. A method of tuning the signal strength indicator in a radio telephone having a logic section which controls the operation, comprising the steps of:
- connecting external tuning equipment (2) to the radio telephone's (1) antenna interface (31) and auxiliary equipment interface (32) or corresponding interfaces,
- applying a test signal from the tuning equipment (2) to the radio telephone antenna interface (31),
- the tuning equipment (2) reading the received signal strength indicator (RSSI) reading via an A/D-converter and via the logic section (10) and the auxiliary equipment interface (32), and calculating a compensating value corresponding to the reading, said compensating value is stored in a non-volatile memory of the logic section (10),
- whereby, during the operation of the radio telephone, the logic section via the A/D-converter (15) reads the received signal strength indicator (RSSI) reading and corrects it with the stored compensating value in order to select the best channel.

2. Tuning method according to claim 1, characterized in that the tuning can be made without opening the radio telephone (1) casing.

3. Tuning method according to claim 1 or 2, characterized in that in the tuning equipment (2) there is arranged a computer (20), which automatically or semiautomatically via the logic section reads the readings of the A/D-converter (15) connected to the received signal strength indicator (RSSI).

4. Tuning method according to any previous claim, characterized in that the tuning is made sequentially for several selected operating conditions of the radio telephone (1), or for several channels or channel ranges and for one or more operating temperature ranges, and for one or more levels, whereby the tuning equipment (2) receives information about the radio telephone operating conditions via the auxiliary equipment interface (32), and whereby a compensating value corresponding to each operating condition is stored in the non-volatile memory of the logic section (10).

## Patentansprüche

1. Verfahren zur Abstimmung des Signalstärkeindikators in einem eine Steuereinheit zur Überwachung des Betriebs aufweisenden Funktelefon mit den folgenden Schritten:
- anschließen eines externen Abstimmgeräts (2) an den Antennenanschluß (31) und den Anschluß für Zusatzgeräte (32) oder korrespondierende Anschlüsse des Funktelefons (1),
- anlegen eines Testsignals vom Abstimmgerät (2) an den Antennenanschluß (31),
- einlesen des Wertes des Signalstärkeindikators über einen A/D-Wandler, die Steuereinheit (10) und den Anschluß für Zusatzgeräte (32) in das Abstimmgerät (2), errechnen eines zu dem eingelesenen Wert korrespondierenden Kompensationswertes und speichern dieses Kompensationswertes in einem nichtflüchtigen Speicher der Steuereinheit (10),
- wobei während des Betriebs des Funktelefons der Wert des Signalstärkeindikators von der Steuereinheit über den A/D-Wandler (15) gelesen und anschließend mit dem gespeicherten Kompensationswert korrigiert wird, um den besten Kanal auszuwählen.

2. Verfahren zur Abstimmung nach Anspruch 1, **dadurch gekennzeichnet, daß** derAbstmmvorgang ohne das Gehäuse des Funktelefons (1) zu öffnen durchgeführt werden kann.

3. Verfahren zur Abstimmung nach Anspruch 1 oder 2, **dadurch gekennzeichnet, daß** im Abtimmgerät (2) ein Computer (20) enthalten ist, der automatisch oder halbautomatisch die Werte des an den Signalstärkeindikator angeschlossenen A/D-Wandlers (15) über die Steuereinheit einliest.

4. Verfahren zur Abstimmung nach einem der vorherigen Ansprüche, **dadurch gekennzeichnet, daß** die Abstimmung nacheinander für mehrere ausgewählte Betriebsbedingungen des Funktelefons (1), oder für mehrere Kanäle oder Kanalbereiche und für einen oder mehrere Betriebstemperaturbereiche, und für einen oder mehrere Pegel durchgeführt wird, wobei das Abstimmgerät (2) Informationen über die Betriebsbedingungen des Funktelefons über den Anschluß für Zusatzgeräte (32) erhält, und ein Kompensationswert für jede Betriebsbedingung in dem nichtflüchtigen Speicher der Steuereinheit (10) gespeichert wird.

## Revendications

1. Procédé pour accorder l'indicateur d'intensité du signal dans un radiotéléphone comportant une section logique qui commande l'opération, comprenant les étapes consistant à :
- connecter un équipement d'accord externe (2) à l'interface d'antenne (31) et à l'interface d'équipement auxiliaire (32) ou aux interfaces correspondantes du radiotéléphone (1),
- appliquer un signal de test provenant de l'équipement d'accord (2) à l'interface d'antenne du radiotéléphone (31),
- effectuer une mesure par l'équipement d'accord (2) de l'indicateur d'intensité du signal reçu (RSSI) par l'intermédiaire d'un convertisseur analogique/numérique et par l'intermédiaire de la section logique 10 et de l'interface d'équipement auxiliaire (32) et calculer une valeur de compensation correspondant à la mesure, ladite valeur de compensation étant mémorisée dans une mémoire rémanente de la section logique (10),
- d'où il résulte que, pendant le fonctionnement du radiotéléphone, la section logique par l'intermédiaire du convertisseur analogique/numérique (15) lit la mesure de l'indicateur d'intensité du signal reçu (RSSI) et la corrige avec la valeur de compensation mémorisée afin de sélectionner le meilleur canal.

2. Procédé d'accord selon la revendication 1, caractérisé en ce que l'accord peut être effectué sans ouvrir le boîtier du radiotéléphone (1).

3. Procédé d'accord selon la revendication 1 ou 2, caractérisé en ce que dans l'équipement d'accord (2) est disposé un ordinateur (20), lequel lit automatiquement ou semi-automatiquement par l'intermédiaire de la section logique les mesures du convertisseur analogique/ numérique (15) connecté à l'indicateur d'intensité du signal reçu (RSSI).

4. Procédé d'accord selon l'une quelconque des revendications précédentes, caractérisé en ce que l'accord est effectué séquentiellement pour les nombreuses conditions de fonctionnement sélectionnées du radiotéléphone (1) ou pour les nombreux canaux ou plages de canaux et pour une ou plusieurs plages de températures de fonctionnement et pour un ou plusieurs niveaux, d'où il résulte que l'équipement d'accord (2) reçoit les informations concernant les conditions de fonctionnement du radiotéléphone par l'intermédiaire de l'interface d'équipement auxiliaire (32) avec pour effet qu'une valeur de compensation correspondant à chaque condition de fonctionnement est mémorisée dans la mémoire rémanente de la section logique (10).
